# EUROPÄISCHE PATENTANMELDUNG

(11) **EP 0 677 933 A2**
(43) Veröffentlichungstag der Anmeldung: **18.10.1995**
(21) Anmeldenummer: 95103087.3
(22) Anmeldetag: 04.03.1995
(51) Int. Cl.: H04H 7/00

(54) **Stellglied mit taktiler Rückkopplung**

(30) Priorität: 12.04.1994 CH 1060/94
(71) Anmelder: STUDER Professional Audio AG, CH-8105 Regensdorf ZH (CH)
(72) Erfinder: Zwicky, Paul, CH-8157 Dielsdorf (CH); Sauter, Lorenz, CH-8954 Geroldswil (CH); Huber, Robert, CH-8103 Unterengstringen (CH); Fisch, Peter, CH-1020 Renens (CH)

(57) **Zusammenfassung**

Um bei Vorrichtungen zur Betätigung eines Stellgliedes (4) für die Verarbeitung eines Audiosignales, mit einem Eingabeelement (2) die Reaktion auf die Veränderungen des Stellgliedes zu verbessern, soll eine Auswerteeinheit (9), die zur Ausgabe einer Rückmeldung an das Eingabeelement ausgebildet und angeordnet ist, vorgesehen werden. So könnten erreichte Sollwerte direkt beispielsweise im Eingabeelement fühlbar gemacht werden können.

## Beschreibung

Die Erfindung betrifft eine Vorrichtung zur Betätigung eines Stellgliedes gemäss dem Oberbegriff des Patentanspruches 1.

Stand der Technik sind Steuer- und Regelsysteme der Audio-Technik, die der Mensch mit Beteiligung seiner Sinnesorgane beeinflussen kann. Dabei ist es üblich, dass mehrere seiner fünf Sinne im gleichen Regelkreis arbeiten. Beispielsweise betätigt der Mensch mit Hilfe seines Tastsinnes eine Taste oder einen Hebel und überwacht die Wirkung, die er damit erreicht, mit dem Auge, in seiner Umgebung oder an einem Instrument. Erkennt er mit dem Gehirn, dass er eine Eingabe über das Auge oder das Ohr erhält und dass beispielsweise die Wirkung eine Grenze oder einen Sollwert erreicht hat, so wirkt er, wiederum gesteuert durch das Gehirn, auf die Taste oder den Hebel ein, so dass die Wirkung, z.B. Lautstärke, Klangfarbe usw. verändert wird. Mit anderen Worten ist es üblich, in solchen Fällen mehrere Sinnesorgane in den Regelkreis einzubeziehen.

Solche Lösungen haben Nachteile, die darin bestehen, dass die Reaktionsgeschwindigkeit herabgesetzt ist und dass die Reaktion zeitlich ungenau erfolgt oder in ihrem Ausmass ungenau dosiert ist. Hauptgrund dafür ist der Umstand, dass der Mensch eine Umsetzung der Signale vornehmen muss, die von mehreren Sinnesorganen ausgehend über das Gehirn laufen müssen, wo sie transformiert und koordiniert werden müssen, so dass sie für das Gehirn vergleichbar werden und eine entsprechende Reaktion ausgelöst werden kann.

Aus der WO 92/18943 ist ein System mit Inkrementalgebern zum Einstellen von Parametern in Audio-Mischpulten bekannt, bei dem über einen zuschaltbaren Mechanismus bei Erreichen von Extrem- oder Endwerten, die den Einstellbereich begrenzen, der Inkrementalgeber blockiert werden kann. Einstellwerte, die zwischen diesen Endwerten liegen, werden dem Bediener durch optische Anzeigen bekanntgemacht.
Damit wird bei diesem System beim Einstellen der Parameter ein Regelkreis gebildet, der über mehrere Sinnesorgane - Hand, Auge - reicht und eine laufende Umsetzung der optisch erhaltenen Informationen in Handbewegungen bedingt. Dies weil Rückmeldungen über die aktuelle Einstellung der Parameter trotzdem über das Auge wahrgenommen werden und allfällige Korrekturen von Hand eingegeben werden müssen.

Hier will die Erfindung ansetzen und eine Vorrichtung und ein Verfahren schaffen, die die genannten Nachteile nicht aufweisen. Die Erfindung will ferner eine Vorrichtung schaffen, die in Steuersystemen so angewendet werden kann, dass daraus durch die Wirkverbindung mit einem Menschen ein Regelsystem entsteht, welches die genannten Nachteile vermeidet.

Zur Lösung dieser Aufgabe wird eine Vorrichtung vorgeschlagen, die ein Interface zum Menschen aufweist, welches die am Regelvorgang beteiligten Sinnesorgane optimiert, beispielsweise indem möglichst schnell reagierende Sinne oder möglichst wenig belastete Sinne beteiligt werden. Vorzugsweise geschieht das dadurch, dass das Interface so ausgebildet ist, dass es nur mit einem einzigen Sinnesorgan zusammenarbeitet. Dies kann beispielsweise derart geschehen, dass Steuerungen, die durch einen Hebel betätigt werden, über diesen auch eine Rückmeldung darüber an den Menschen abgeben, dass ein Sollwert erreicht ist. Mit der erfindungsgemässen Vorrichtung können solchen Hebeln oder Drehknöpfen Rasterungen, Anschläge und andere übliche Markierungen von Stellen vorgegeben werden und zwar ausschliesslich über eine geeignete Programmierung oder Software.

Die durch die Erfindung erreichten Vorteile sind insbesondere darin zu sehen, dass die Reaktionsgeschwindigkeit im Regelkreis erhöht wird, was üblicherweise wiederum zur Folge hat, dass ein Überschwingen der gesteuerten Grössen vermindert werden kann. Ein weiterer Vorteil besteht darin, dass die Steuerung praktisch so ausgebildet werden kann, dass durch andere Vorgänge bereits hochbelastete Sinnesorgane, wie z.B. das Auge und das Ohr, aus dem Regelkreis herausgehalten werden können. Dadurch werden die Vorgänge im Regelkreis insgesamt verbessert und der Mensch wird entlastet, indem seine Sinnesorgane gleichmässiger und für eine besimmte Wirkung gezielter belastet werden können. Beispielsweise kann sich ein Toningenieur mit seinem Ohr ganz auf ausgewählte Aspekte einer Aufnahme oder Wiedergabe konzentrieren und andere Aspekte seinem Tastsinn überlassen. Es ist dank der Erfindung nun aber auch möglich, Eingabeelemente wie Schieber, Räder usw. für verschiedene Funktionen zu verwenden und den Eingabeelementen für jede Funktion speziell geeignete Anschläge, Rasterungen usw. zuzugeben.

Im folgenden wird die Erfindung anhand von einen Ausführungsweg darstellenden Figuren näher erläutert. Es zeigen:
Figur 1 in schematischer Darstellung eine erfindungsgemässe Vorrichtung,
Figur 2 und 3 je ein Element der Vorrichtung und
Figuren 4 und 5 je eine weitere Ausführung der Vorrichtung.

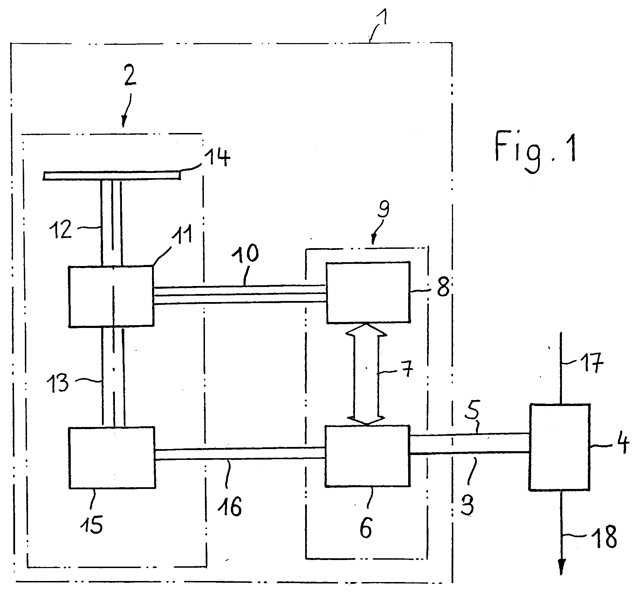

Fig. 1 zeigt ein Schema einer erfindungsgemässen Vorrichtung. Darin erkennt man eine Eingabeeinheit 1 mit einem Eingabeelement 2, das beispielsweise durch die Hand eines Menschen betätigt werden kann und über das Werte oder analoge Signale eingegeben werden können. Eine Leitung 3 verbindet die Eingabeeinheit 1 mit einem Stellglied 4, das eine bestimmte Wirkung in einem Audio-System hat. Zusätzlich erkennen wir eine Leitung 5 für Signale, die Rückmeldungen aus dem Stellglied 4 entsprechen. Diese Rückmeldungen werden in das Eingabeelement 2 zurückgeführt, das damit zum kombinierten Ein- und Ausgabeelement wird. Damit schliesst sich hier ein Regelkreis über die Hand des Menschen, der die Vorrichtung bedient. Das Stellglied 4 ist in der Eingabeeinheit 1 beispielsweise mit einem Speicher 6 verbunden, der wiederum über einen Bus 7 an einen Rechner 8 angeschlossen ist. Rechner 8 und Speicher 6 bilden zusammen eine Auswerteeinheit 9. Der Speicher 6 enthält Informationen über die aktuelle Stellung des Stellgliedes 4. Diese Informationen können vom Rechner 8 aufbereitet werden, indem dieser beispielsweise die Stellung des Stellgliedes 4 laufend durch Berechnung aus den eingehenden Signalen ermittelt, oder die Informationen werden diesem zugeführt, sodass dieser darüber sozusagen "Buch führt". Im Speicher 6 sind beispielsweise Informationen vorhanden, die angeben, ob das Stellglied 4 in einer Anfangs- oder Endstellung steht, ob es in der Mitte seines Arbeitsbereiches steht usw.
Der Rechner 8 ist über einen Bus oder Leitungen 10 mit einem Eingabeelement 11, beispielsweise einem an sich bekannten Inkrementalgeber verbunden. Über je eine mechanische Verbindung 12 und 13 ist der Inkrementalgeber 11 einerseits mit einem Handrad 14 oder Drehknopf und mit einer steuerbaren elektrischen Bremse 15 verbunden. Diese ist wiederum über Leitungen 16 mit dem Speicher 6 verbunden. Inkrementalgeber 11 und Bremse 15 sind hier in rotationssymmetrischer Bauweise angedeutet und damit sind als mechanische Verbindungen 12 und 13 Wellen im Einsatz. Das ist hier aber nur beispielshalber so. Ebenso wären entsprechend arbeitende lineare Elemente möglich.
Die Arbeitsweise dieser Vorrichtung ist die folgende. Durch Verstellen des Handrades 14 gibt der Inkrementalgeber 11 in bekannter Weise elektrische Signale über die Leitungen 10 an den Rechner 8 ab. Dieser verarbeitet die eingehenden Signale unter Berücksichtigung des Speicherstandes und modifiziert den Stand im Speicher 6 so, dass nun ein neuer Speicherstand gilt, der im Speicher 6 eingelesen ist und aus dem ein Signal generiert wird, durch welches das Stellglied 4 (bzw. dessen beweglicher Teil) sich in einer durch die Signale bestimmten Richtung und Strecke in eine neue Stellung schiebt. Der Rechner 8 vergleicht auch den neuen Speicherstand mit vorgegebenen Werten im Speicher 6. Solche vorgegebenen Werte geben beispielsweise eine charakteristische Stellung des Stellgliedes 4 an. Werden solche Stellungen erreicht oder überschritten, so werden entsprechende Signale über die Leitungen 16 an die Bremse 15 abgegeben. Dadurch kann diese teilweise oder ganz bremsen, wenn sie zuvor gelöst war oder umgekehrt, wobei der dadurch erzeugte Widerstand über die mechanischen Verbindungen 12 und 13 in das Handrad 14 eingeleitet wird. Das bedeutet, dass der Mensch, der das Handrad 14 bedient, eine Rückmeldung über die Stellung des Stellgliedes 4 direkt auf das Handrad 14 erhält, obwohl das Eingabelement, hier der Inkrementalgeber 11, dazu an sich nicht in der Lage ist, oder, wenn er das könnte, nur über seine eigene Stellung informieren könnte. Damit schliesst sich der Regelkreis über die Hand des Menschen, der das Handrad 14 bedient.
Das Stellglied 4 kann beispielsweise ein Potentiometer, ein Ventil oder irgend ein anderes auch digital arbeitendes Element sein, das Stellgrössen, also Werte oder Parameter eines Zustandes an seinem Eingang 17 in eine andere Stellgrösse an seinem Ausgang 18 umwandelt.

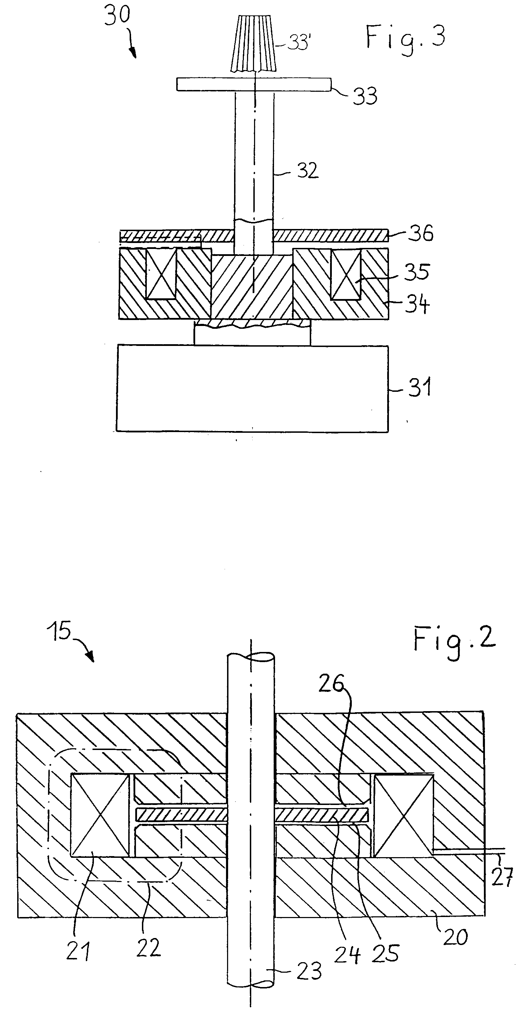

Figur 2 zeigt schematisch einen Schnitt durch eine Bremse 15, die hier beispielsweise als Magnetpulverkupplung ausgebildet ist. Darin erkennt man einen Eisenkern 20 und eine Spule 21, die zusammen einen Magnetkreis 22 bilden. In diesen greift eine, mit einer Welle 23 fest verbundene Scheibe 24 ein. Zwischen dem Eisenkern 20 und der Scheibe 24 sind Spalte 25 und 26 vorgesehen, die mit Eisenpulver gefüllt sind. Wird ein Magnetfeld aufgebaut, so bildet das Eisenpulver eine mechanische Verbindung über die Spalte 24 und 26 und die Kupplung greift. Im Sinne der Ausführung von Figur 1, ist das Stellglied 4 oder insbesondere der Speicher 6 über die Leitungen 27 an die Spule 21 zur Betätigung angeschlossen.

Figur 3 zeigt eine konstruktive Einheit 30, die aus Elementen besteht, die aus der Figur 1 bekannt und dort mit 11, 12, 13, 14 und 15 bezeichnet sind. Dabei ist ein Inkrementalgeber 31 über eine Welle 32 mit einem Handrad 33 oder Drehknopf 33' mechanisch verbunden. Mit dem Gehäuse des Inkrementalgebers 31 ist ein Ringkern 34 verbunden, in den eine Spule 35 eingelassen ist. Auf der Welle 32 ist unverdrehbar aber in achsrichtung verschiebbar eine Scheibe 36 angeordnet, die bei aktiviertem Magnetfeld an den Ringkern 34 herangezogen wird, so dass sie eine Stellung 36' einnimmt, was eine Bremswirkung ergibt, so dass das Drehen der Welle 32 erschwert ist. Damit ergeben die Elemente 34, 35 und 36 zusammen wieder eine Bremse 15 wie in Fig. 1 gezeigt.

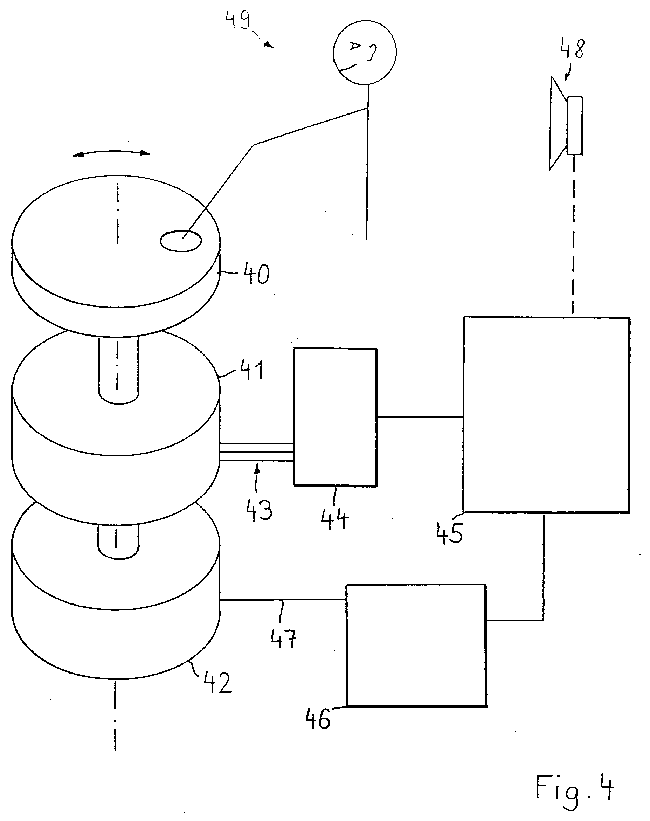

Eine weitere Ausführung eines solchen Steuersystems im Audio-Bereich ist aus der Figur 4 ersichtlich. Zur Eingabe ist wieder ein Handrad 40, hier auch unter dem begriff "Shuttle Wheel" bekannt, vorgesehen. Dieses ist mit einem Inkrementalgeber 41 also einer Signalquelle und einer elektrischen Bremse 42 mechanisch verbunden. Leitungen 43 verbinden den Inkrementalgeber 41 mit einem Rechner 44, der wiederum mit einem Audio-Speicher 45 verbunden ist. Als Audio-Speicher sind CD-Speicher, Tonbandgeräte, Festplattensysteme oder auch andere Festspeicher (RAMs) denkbar. Der Audio-Speicher 45 ist weiter an eine Auswerteeinheit 46 angeschlossen, die wiederum über eine Leitung 47 mit der Bremse 42 verbunden ist. An den Audio-Speicher 45 ist ferner und hier nur zur Verdeutlichung eines nachfolgend beschriebenen Vergleiches, jedoch nicht unbedingt in Wirklichkeit, ein Ausgabeelement, wie beispielsweise ein Lautsprecher 48, über hier nicht genauer gezeigte aber an sich bekannte Elemente wie Verstärker usw., angeschlossen. In das ganze System ist auch der Mensch 49 eingebunden, der mit seiner Hand und seinem Tastsinn das Handrad 40 betätigen kann, und der über seinen Hörsinn und sein Ohr an den Lautsprecher "angeschlossen" ist, d.h. diesen hören kann.
Mit diesem System kann man beispielsweise auf einem Tonträger, d.h. im Audio-Speicher 45 eine bestimmte Stelle suchen wollen, was beim Editieren oft vorkommt. Dabei ist der Mensch 49 einerseits über das Handrad 40, den Inkrementalgeber 41, den Rechner 44 mit einem Antrieb oder einer Auslesevorrichtung des Audio-Speichers verbunden und kann diesen auf diesem Wege beeinflussen und ihm Befehle erteilen. Andererseits ist der Mensch 49 auch über den Lautsprecher 48 mit dem Speicherinhalt, also dem gespeicherten Ton verbunden und er kann diesen so wahrnehmen. So kann er zunächst auf an sich bekannte Weise beispielsweise den Beginn einer Aufzeichnung, also den ersten Ton suchen. Dazu dreht er am Handrad 40 solange bis er den Ton hört. Sobald er den Ton hört dreht er wieder am Handrad um den Antrieb des Tonträgers abzuschalten. So könnte er nun beispielsweise das Tonband an dieser Stelle schneiden. Das vorliegende erfindungsgemässe System erlaubt aber auch eine genauere Bestimmung der gesuchten Stelle. Die Auswerteeinheit 46 kann beispielsweise so programmiert oder konstruiert sein, dass sie über die Leitung 47 ein Signal abgibt, sobald sie auf dem Tonträger oder Speicher Signale erkennt. Das bedeutet, dass das Auftauchen eines Signales in der Leitung 47 die Bremse 42 aktiviert, was der Mensch 49 in seiner Hand sofort spürt. So kann er viel schneller reagieren und durch eine Drehung am Handrad 40 blitzschnell die Bewegung des Audio-Speichers 45 stoppen. Die Bremse 42 kann auch durch einen Vibrator ersetzt oder ergänzt werden, so dass Markierungen durch eine Vibration im Handrad 40 angezeigt werden.

Durch dieses Verfahren und solche Anordnungen ist es möglich, sehr genau solche Stellen beispielsweise auf einem Tonband oder Speicher aufzufinden, denn sie können durch reine Signalerkennung ermittelt werden, so dass das Hören nur noch zur "groben" Suche benützt wird. Die "feine" Suche erfolgt unter Ausschaltung des Gehörs.
Dabei ist die Auswerteeinheit 46 von besonderer Bedeutung. Sie hat die Aufgabe, beispielsweise in einer Signalfolge eine Stelle, eine Besonderheit oder einen typischen Signalverlauf zu suchen. Beispielsweise zeichnet sich der Beginn eines Musikstückes durch ein plötzlich gesteigertes Signal aus. Die Auswerteeinheit 46 untersucht das Signal auf diese Besonderheit, z.B. darauf, ob ein vorgegebener Schwellwert erreicht wird. Dazu könnte eine Auswerteeinheit 46 z.B. aus einem Gleichrichter mit einem nachgeschalteten Verstärker aufgebaut sein. Der Gleichrichter liefert der Bremse 42 oder dem darin befindlichen Magneten ein Gleichstromsignal, so dass die Bremse bremst, sobald ein solches Signal gefunden ist. Damit kann der Mensch das Auftreten eines solchen Signales direkt in der Hand spüren und so viel schnell reagieren.

Mit anderen Worten erhält man gemäss der Erfindung nun einen geschlossenen äusserst schnell reagierenden Regelkreis 50 (Fig. 4) der im Gegensatz steht zu einem Regelkreis gemäss dem Stand der Technik, der über die Elemente 45, 44, 41, 40, das Gehirn des Menschen 49 und den Lautsprecher 48 verläuft. Da die Umsetzung von Signalen zwischen den verschiedenen Sinnesorganen des Menschen entfallen kann, ist die erfindungsgemässe Vorrichtung eben reaktionsschneller. Eine typische Anwendung in der Audio-Technik kann bei vielen Stellelementen beispielsweise in Mischpulten oder Audio-Video Schnittsystemen gesehen werden.

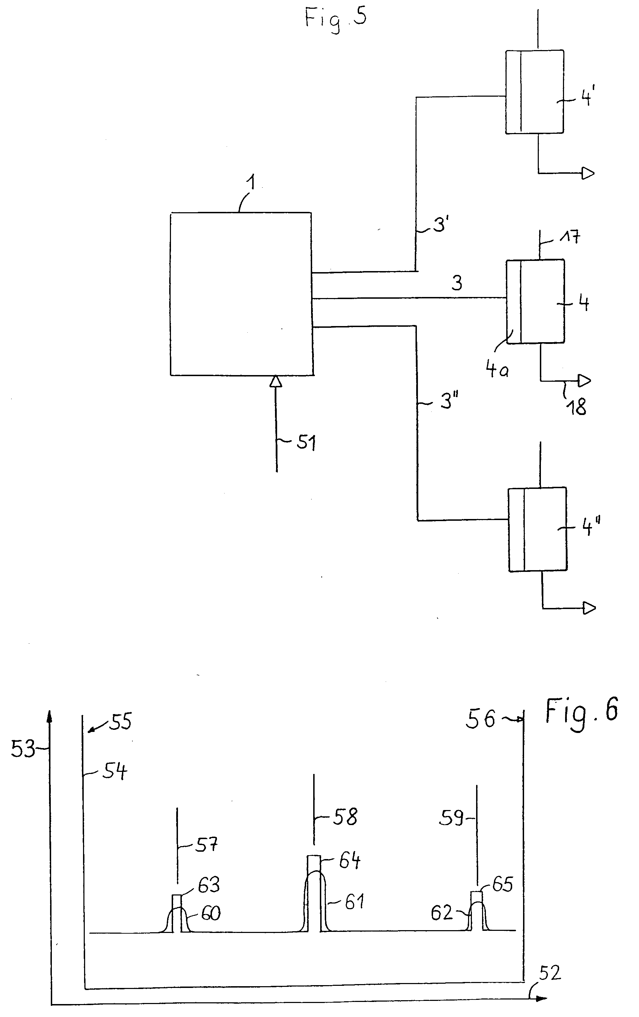

Eine solche weitere Anwendung der Erfindung kann aus der Figur 5 ersehen werden. Figur 5 zeigt Teile, die schon aus der Figur 1 bekannt und deshalb mit gleichen Bezugszeichen versehen sind. Insbesondere sind hier mehrere Stellglieder 4, 4', 4'' gezeigt, die alle über Leitungen 3, 3', 3'' an die Eingabeeinheit 1 angeschlossen sind. Nun kann man mit dem Eingabeelement 2 der Eingabeeinheit 1 abwechslungsweise mehrere Stellglieder 4, 4', 4'' betätigen. Die Auswahl kann über einen Eingang 51, der in den Speicher 6 mündet, getroffen werden. Die einzelnen Stellglieder 4 können auch einen Speicher 4a aufweisen, der Informationen über die zuletzt getroffene Einstellung des Stellgliedes gespeichert halten. So kann der Rechner 9 sich die Speicherung dieser Informationen sparen und die Leitung 5 (Fig. 1) fällt weg. In den Speichern 4a sind auch alle Angaben gespeichet, die das spezielle Verhalten des Stellgliedes charakterisieren. Beispielsweise kann für die Betätigung des Stellgliedes 4 vorzugsweise eine Einstellung von Extremwerten gewünscht werden, so dass nur interessiert, ob dass Stellglied "offen" oder "geschlossen" ist. Dann soll das Eingabeelement 2 so beeinflusst werden, dass die Bremse 15 zwei Anschläge simuliert, zwischen denen das Handrad 14 frei drehbar ist. Oder das Stellglied 4' soll vorzugsweise auf besondere Werte eingestellt sein. Dann kann über die Bremse 15, die bei bestimmten Werten immer vorübergehend betätigt wird, eine Rasterung simuliert werden anstatt einer Skala, die neben dem Handrad 14 grafisch diesen Umstand andeuten würde. Dagegen könnte es auch wünschbar sein, das Stellglied 4 frei laufen zu lassen, weil nur seine Bewegung eine Signaländerung bewirkt. Dann braucht die Bremse 15 nie aktiviert zu werden.
Alle diese verschiedenen und nur als Beispiele genannten Wirkungen können durch ein und dieselbe Eingabeeinheit 1 erreicht werden. Damit kann man beispielsweise in Mischpulten für Audioanwendungen sehr einfach gewisse Eingabeelemente mehrfach mit Funktionen belegen und trotzdem für jede Funktion rein softwaremässig dem Eingabeelment ein bestimmtes Verhalten verleihen.

Figur 6 zeigt nochmals die verschiedenen Möglichkeiten der erfindungsgemässen Lösung auf. Angenommen längs einer Achse 52 sei ein Weg oder eine Zeit und längs einer Achse 53 eine Bremskraft oder eine Schwingungsamplitude einer mechanischen Schwingung aufgetragen, so lassen sich verschiedene Charakteristiken bilden. Mit einer Bremskraftcharakteristik gemäss einer Kurve 54 lässt sich für einen Hebel oder einen Drehknopf ein Arbeitsbereich zwischen festen Anschlägen 55 und 56 bilden. Elemente 57, 58 und 59 einers Rasters lassen sich durch erhöhte Bremskraft wie sie Erhebungen 60, 61, 62, oder Schwingungen mit Amplituden 63, 64, 65 andeuten und im Handrad bemerkbar machen und so entsprechende graphische Angaben vermeiden.

## Patentansprüche

1. Vorrichtung zur Betätigung eines Stellgliedes (4) für die Verarbeitung eines Audiosignales, mit einem Eingabeelement (2), gekennzeichnet durch, eine Auswerteeinheit (9), die zur Ausgabe einer Rückmeldung an das Eingabeelement ausgebildet und angeordnet ist.

2. Vorrichtung nach Anspruch 1, dadurch gekennzeichnet, dass die Eingabeeinheit (1) ein handbetätigbares Eingabeelement (2) aufweist, das über die Auswerteeinheit (9) an das Stellglied (4) angeschlossen ist.

3. Vorrichtung nach Anspruch 1 und 2, dadurch gekennzeichnet, dass die Rückmeldung an das Eingabeelement mit dem Tastsinn erkennbar ausgebildet ist.

4. Vorrichtung nach Anspruch 3, dadurch gekennzeichnet, dass das Eingabeelement (2) eine steuerbare Bremse (15) aufweist.

5. Vorrichtung nach Anspruch 3, dadurch gekennzeichnet, dass das Eingabeelement (2) zur Übertragung von Vibrationen ausgebildet ist.

6. Vorrichtung nach einem der Ansprüche 1 bis 5, dadurch gekennzeichnet, dass die Auswerteeinheit abwechslungsweise an mehrere Stellglieder (4, 4', 4'') angeschlossen ist, zur Betätigung durch ein einziges Eingabeelement.

7. Verfahren zum Regeln einer Stellgrösse über ein Stellglied (4), dadurch gekennzeichnet, dass dem Stellglied aus einer Signalquelle Signale zugeführt werden, dass aus den Signalen laufend Werte, die die Stellung des Stellgliedes darstellen, ermittelt werden, dass diese mit vorgegebenen Werten verglichen werden, und dass aus dem Vergleich Signale zur Beeinflussung der Signalquelle gewonnen werden.

8. Verfahren nach Anspruch 5, dadurch gekennzeichnet, dass die Signale digitale Signale sind.

9. Vorrichtung nach Anspruch 1, dadurch gekennzeichnet, dass die Auswerteeinheit (9) eine Anzahl gespeicherter Werte enhält, die zusammen eine Rasterung ergeben, die über das Eingabeelement (2) direkt angezeigt wird.
